# EUROPEAN PATENT APPLICATION

(11) **EP 4 303 656 A1**
(43) Date of publication of application: **10.01.2024**
(21) Application number: 22183942.6
(22) Date of filing: 08.07.2022
(51) Int. Cl.: G03F 7/00, B29C 33/00, B29C 37/00, B29C 43/00, B29C 70/00, C09J 7/40, G03F 7/16

(54) **REMOVABLE TEXTURED LAYER**

(71) Applicant: Morphotonics Holding B.V., 5503 LM Veldhoven (NL)
(72) Inventor: KIERKELS, Jules, 6093 JX Heythuysen (NL); TER MEULEN, Jan Matthijs, 5644 NR EINDHOVEN (NL); Veldhuizen, Leon Willem, 3532 TS Utrecht (NL); VAN DER LUBBE, Bodine, 5711 NK Someren (NL)
(74) Representative: Patentwerk B.V.

(57) **Abstract**

The invention pertains to a substrate, the substrate comprising, at least one surface comprising a first three-dimensional texture and a removable coating characterized in that the coating covers the first three-dimensional texture, the coating comprises a second three-dimensional texture, the second three-dimensional texture is in contact with the first three-dimensional texture, which second three-dimensional texture is an essentially exact negative image of the first three-dimensional texture.

## Description

The invention pertains to a removable textured layer.

Functional textured layers are surfaces having a texture in the nano- or micrometer range. This can be a random texture, or amongst others diffractive gratings, slanted gratings, blazed gratings, micro-lens arrays, lenticulars, bars, pyramids, prism lines or even a blank surface.

The use of functional textured layers on devices such as displays or solar cells is an important topic. The smart usage of such layers can enhance performance, reduce cost or improve the visual appearance of the product. For example, diffusing layers are used in displays, enabling the use of thinner LED backlight concepts and illuminating the display from the sides. Other new high-tech possibilities are the integration of functional textured layers into solar panels improving their efficiency or integration in organic light-emitting diode (OLED) lighting panels to extract more light.

Functional textured layers can be made by use of nanoimprinting. In this case the substrate, or stamp, or both are coated with a resin (also called lacquer or resist). After pressing the stamp on the substrate with resin in between, the textured resin is cured to a solid phase. The curing method can be thermal or by use of radiation such as UV light. With this technique texturing can be carried out with micro- or nano-sized features.

Functional textured layers are prone to handling defects no matter whether the texture is present on a master, an intermediate stamp, or an imprinted component.

To protect functional textured layers, typically a foil in combination with an adhesive layer is used. The adhesive layer may be an acrylate layer, a layer of (poly)urethane in combination with a solvent or acrylate monomer, as described in JP2013211493. JP2017014514 discloses a combination of a foil and an adhesive layer which consists of a combination of a monomer and a polymer with molecular weight between 50,000-1,000,000.

JP2011195598 and JP2009283927 disclose more complex adhesive compositions including (meth)acrylates and fillers.

WO2015111310 and JP2015021065 disclose an alkyl (meth) acrylate material having an alkyl group having 1 to 18 carbon atoms as material for the adhesive layer. WO2015111310 discloses an adhesive material in combination with an additional intermediate layer, in order to ensure good adhesion of the adhesive layer to the protective sheet. Also KR101283485 discloses a three-layer stack.

The above mentioned protection foils with adhesive layer are laminated onto the wafer by use of a lamination or manual pressing process. Foils can also be used without a pressure sensitive adhesive to provide protection. The drawback of both methods is that the risk on air entrapment is high and the adhesive layer does not fully cover steep or deep textures.

Another method to protect a flat, planar and textured or non-textured wafer is to add onto the wafer surface a protective acrylate material, a polymer, or a photoresist, enabling for example dicing of the wafer. An example is described in JP2013211439 and KR2019009028, using a high viscous (poly)urethane material in combination with monomers with glass transition temperature above 20°C.

Typically spin-coating is used, but spin-coating is complex to use for larger surfaces. The prior art discusses the protection of round wafers. But not all textured surfaces are round. Rectangular surfaces are complex to spin-coat. Thirdly, also in a spincoat method it is likely that there is no conformal protection of a textured surface, having steep textures not filled with resin.

As a result, these acrylate or foil based layers do not cover the surface by 100%, leaving air bubbles in between the surface and the acrylate material. Moreover, said acrylate materials could possibly adhere to UV cured acrylate surfaces on a substrate, or could leave residues on the surface when removed.

It is an object of the present application to provide a material which is able to protect functional textured layers comprising of e.g. acrylates but also metal, glass and ceramics surfaces from mechanical wear and soiling by dust or dirt, said material should be, at the same time, easy to remove from said textured layers without any damage to said functional textured layer.

The object is achieved by a substrate, the substrate comprising, at least one surface comprising a first three-dimensional texture and a removable coating characterized in that the coating covers the first three-dimensional texture, the coating comprises a second three-dimensional texture, the second three-dimensional texture is in contact with the first three-dimensional texture, which second three-dimensional texture is an essentially exact negative image of the first three-dimensional texture.

According to the application, "essentially exact" means that there are no significant differences between different structures which let said structures deviate from being negative images of each other. "No significant differences" means that e.g. none of the two structures misses recessions and/or elevations compared to its negative image.

The substrate according to the application may be a rigid plate or block of durable material such as glass, silica, quartz, metal like steel, copper, or aluminum, or ceramics. Also, polymeric materials such as thermosetting resins or ebonite are possible.

In an embodiment, the substrate comprises the first three-dimensional texture on its surface which is of the same material as the bulk and not part of an additional layer of a different material on the surface. The first three-dimensional texture may be amongst others, carved, milled, etched, laser ablated, printed, injection molded, embossed or otherwise machined therein.

In an embodiment, the first three-dimensional texture is part of a layer on the surface of the substrate which is of a different material than the bulk. Said layer may be applied to the substrate in the form of a liquid or viscous precursor resin which is then textured using e.g., a stamp which may be a flexible or rigid stamp, a textured roller, or any other texturing means known to the person skilled in the art. The texturing process typically includes a curing step by heat or radiation such as UV radiation in order to solidify the precursor resin to form the first three-dimensional texture. Typical application techniques for the precursor resin are printing and/or imprinting. As imprinting method a, roll-to-roll-, plate-to-plate- or roll-to-plate techniques could be used. For the application of the precursor resin, either textured or non-textured mold or stamp may be used.

In a subsequent step, the coating is applied.

In an embodiment, the coating is applied in such a way that it completely fills the first three-dimensional texture and is not only laid over it. This means that no air or gas bubbles are left in between parts of the first three-dimensional texture and the coating.

In an embodiment, the coating is applied in the form of a liquid or viscous precursor resin onto the first three-dimensional texture. Typical application techniques for the precursor resin forming the coating are printing methods possibly in combination with a lamination or imprinting step. As printing method as example, ink-jet printing, dispense printing, screen-printing or any other printing technique known to the person skilled in the art may be used. Furthermore all other coating processes known to the person skilled in the art may be used such as spin-coating, spray-coating or slit-coating. As imprinting method, a roll-to-roll-, a plate-to-plate- or a roll-to-plate technique could be used. For the application of the precursor resin, either a textured or a non-textured mold or stamp may be used.

Where relevant, the precursor resin is applied to the first three-dimensional texture after the first three-dimensional texture has been solidified. Said liquid or viscous resin flows conformally to the first three-dimensional texture and forms a layer covering the first three-dimensional texture. Afterwards, the precursor is cured by heat or radiation such as UV radiation or otherwise solidified to form the coating. Said coating then covers the first three-dimensional texture and forms a second three-dimensional texture within the first three-dimensional texture which is a negative image of the first three-dimensional texture.

In an embodiment, the coating can still have a function after it is removed from the first three-dimensional texture. For example, the coating could be used as a functional textured layer itself. Alternatively, since the coating is a negative copy of the first three-dimensional coating, it could be used to indirectly inspect the quality of the first three-dimensional texture, without the risk of damaging the first three-dimensional texture in the inspection process. This requires that the coating can be removed from the first three-dimensional texture without being damaged or deformed.

Furthermore, the coating may, when being removed from the substrate, have the character of a foil with a texture on one side. With this property, the coating may either be adhered to a support such as a glass or metal plate to become a substrate according to the application or it may even by itself become a substrate without further supporting layer. In any case, the removed coating provides a surface with a three-dimensional texture. Said three-dimensional texture may, as described in the present application, by itself be provided with a coating for protection against wear, dust or dirt.

Application of the coating to the first three-dimensional texture can be considered successful if the coating can be removed without damaging the first three-dimensional texture or its substrate. A coating that will essentially not cause any damage to the first three-dimensional texture upon removal will be called "removable" according to the present application. This will occur when the peel force that is required to remove the cured coating from the first three-dimensional texture is lower than all of the following forces:
- the cohesive force of the first three-dimensional texture
- the cohesive force of the cured coating
- the cohesive force of any layer onto which the first three-dimensional texture is stacked (e.g. the substrate of the first three-dimensional texture)
- the cohesive force of any layer onto which the coating is stacked (e.g. the substrate of the coating which might be a flexible foil)
- the adhesive force between any pair of surfaces onto which the first three-dimensional texture is stacked (e.g. the surface between the first three-dimensional texture and its substrate)
- the adhesive force between any pair of surfaces onto which the coating is stacked (e.g. the surface between the coating and its substrate which might be a flexible foil)

The approach in this application is to minimize the peel force that is required to separate the first three-dimensional texture and the coating, while at the same time ensuring a good adhesion and cohesion of the other layers.

In an embodiment, the peel force required to separate the coating from the first three-dimensional textured layer is lower than 100 N/m.

In an embodiment, the peel force required to separate the coating from the first three-dimensional textured layer is lower than 20 N/m.

In an embodiment, the peel force required to separate the coating from the first three-dimensional textured layer is lower than 3 N/m.

All values for the peel forces as described above can be determined by a 180 degrees peel test according to the ISO 8510-2 test standard for rigid articles and the ISO 11339 test standard for flexible articles.

A low surface free energy of the of the first three-dimensional texture is indicative of a low peel force of the cured coating. In an embodiment, the surface free energy of the first three-dimensional texture and/or the coating is < 40 mN/m, resulting in a low peel force that allows for the easy removal of the coating from the first three-dimensional texture without any damages or residues left in the first coating.

In an embodiment, the surface free energy of the first three-dimensional texture and/or the coating is < 30 mN/m, resulting in a low peel force that allows for the easy removal of the coating from the first three-dimensional texture without any damages or residues left in the first coating.

In an embodiment, the surface free energy of the first three-dimensional texture and/or the coating is < 25 mN/m, resulting in a low peel force that allows for the easy removal of the coating from the first three-dimensional texture without any damages or residues left in the first coating.

A low surface free energy can be obtained by certain chemical groups which are located on the surface. Typical chemical groups for this purpose are fluorine containing groups such as fluoroalkyl groups, long alkyl groups, or alkyl siloxane groups on either the first three-dimensional textured surface or on the coating or on both.

Another approach for the successful separation of the first three-dimensional texture and the coating is by reducing the interaction between article and coating. This can be done by ensuring a low density of strong covalent, ionic, or metallic interface bonds and entanglements that are formed between the coating and the substrate. In this way, the amount and strength of the interactions between the two interfaces is limited.

In one embodiment, a low interaction between the first three-dimensional textured surface and the coating is ensured by selecting a combination of material of the first three-dimensional textured coating and coating material such that the coating does not form large quantities of strong bonds with the article. For example, a first three-dimensional texture containing inorganic surface groups such as SiOₓ, SiNₓ, metals, and metal oxides does typically not form strong bonds to organic (e.g. acrylate) surface groups. Following this principle, a coating of a UV-cured acrylic resin on a textured glass or silicon surface can typically be successfully removed.

In another embodiment, a low interaction between the first three-dimensional textured surface and the coating is ensured by passivating or deactivating the functional surface groups of the first three-dimensional textured using a post-treatment of its surface. This post-treatment process can, for example, consist of a deposition step that adds a passivation layer or another inactive layer on top of the first three-dimensional texture, or a plasma passivation or deactivation step that passivates a certain amount of the surface groups that will strongly bond to the coating material.

As liquid or viscous precursor resin for the coating may be used: a prepolymer composition containing at least one monomer or oligomer component having at least one polymerizable C=C double bond as well as at least one multifunctional monomer component, wherein the multifunctional monomer component contains at least two functional groups selected from the group consisting of (meth)acrylates, methyl (meth)acrylates, vinyl ethers, allyl ethers, propenyl ethers, alkenes, dienes, unsaturated esters, allyl triazines, allyl isocyanates, and N-vinyl amides wherein the monomer or oligomer component having at least one polymerizable double bond is selected from the group consisting of (meth)acrylates, methyl (meth)acrylates, vinyl ethers, allyl ethers, propenyl ethers, alkenes, dienes, unsaturated esters, allyl triazines, allyl isocyanates, and N-vinyl amides, and wherein at least one surface-active anti-adhesive additive selected from the group consisting of alkyl-(meth)acrylates, poly-siloxane (meth)acrylates, (per)fluoroalkyl (meth)acrylates, (per)fluoropolyether (meth)acrylates, alkyl vinyl ethers, polysiloxane vinyl ethers, (per)fluoroalkyl vinyl ethers, and (per)fluoropolyether vinyl ethers. In an embodiment, the precursor resin is free of solvents or comprises at most 1 wt.-% of solvents, at most 2 wt.-% of solvents, at most 3 wt.-% of solvents, at most 4 wt.-% of solvents or at most 5 wt.-% of solvents. Solvents according to the present application are all fluids that are able to dissolve a reasonable amount of resin and which, at the same time, have a vapor pressure of 30 hPa or more at 25°C.

Another component that might be used as a component in the liquid or viscous precursor resin for the coating are monomers or oligomers containing at least one polymerizable epoxide group and/or at least one multifunctional monomer component, wherein the multifunctional monomer component contains at least two functional epoxide groups per molecule. Any mixture of one of these epoxide group containing formulations with the components in the previous paragraph might compose a suitable formulation for the formation of the protective textured layer.

For the first three-dimensional textured layer and the coating, different material compositions may be used in order to realize a substantially low peel force between the first three-dimensional texture and the coating. The precursor resin may further comprise a photo-initiator or thermal initiator which may be a radical, cationic or anionic initiator. Suitable initiators are known by a person skilled in the art. Possible radical initiators are azo compounds such as azobisisobutyronitrile, peroxides such as dibenzoylperoxide or peroxodisulfate, phosphine oxides such as, diphenylphosphine oxide, aromatic ketones such as 1-hydroxy-cyclohexylphenyl-ketone or 2-hydroxy-2-methylpropiophenone, or a Norrish type II initiator such as methylbenzoylformate. Possible cationic and anionic initiators are benzenesulfonic acid esters, alkylsulfonium salts or photo base generators such as triphenylsulfonium (cationic), tetrafluoroborate or 2-nitrobenzyl cyclohexylcarbamate (anionic). Depending on the initiator the consolidation may be initiated either thermally or by radiation, e.g. by UV radiation.

In an embodiment, the precursor resin compositions used for the layer and/or the coating may be completely curable apart from the radical initiator. In an embodiment, said resin compositions may comprise of at least 95 wt.-%, at least 98 wt.-%, or at least 99 wt.-% of curable material.

In an embodiment, the precursor resin is free of solvents or comprises at most 1 wt.-% of solvents, at most 2 wt.-% of solvents, at most 3 wt.-% of solvents, at most 4 wt.-% of solvents or at most 5 wt.-% of solvents. In an embodiment, the coating is a pressure-sensitive adhesive which according to the application is produced in situ.

In an embodiment, the coating is adhered to a foil such as a plastic foil. The plastic foil may be applied to the precursor resin prior to solidification or after solidification. The application method can be lamination. The plastic foil may simplify removal of the coating.

In an embodiment, the plastic foil may be adhered to the coating using a pressure-sensitive adhesive.

As the second three-dimensional texture in the coating forms an essentially exact negative image of the first three-dimensional texture during curing, the second three-dimensional texture may, after removal of the coating, be checked with any optical or electron microscopic means for conformity with the first three-dimensional texture in order to check whether the first three-dimensional texture may be damaged during removal of the coating.

The application further pertains to a process for application of a coating onto a substrate, the substrate comprising a three-dimensional texture comprising the steps of providing a substrate comprising a three-dimensional texture, providing a liquid or viscous precursor resin using a coating process in such a way that the liquid precursor resin fills the three-dimensional texture, solidifying the liquid precursor resin to obtain the coating.

Typical coating processes for applying the precursor resin are printing methods possibly in combination with a lamination or imprinting step. As printing method as example, ink-jet printing, dispense printing, screen-printing or any other printing technique known to the person skilled in the art may be used. Furthermore all other coating processes known to the person skilled in the art may be used such as spin-coating, spray-coating or slit-coating. As imprinting method, a roll-to-roll-, a plate-to-plate- or a roll-to-plate technique could be used. For the application of the precursor resin, either a textured or a non-textured mold or stamp may be used.

In order to make sure that the three-dimensional texture is filled by the precursor resin, the viscosity and the surface tension of the precursor resin may be chosen depending of the material and the fineness of the first three-dimensional texture. Solidification may be carried out by any technique known in the art such as heating for thermosetting and/or dissolved precursor resins, UV or visible light, low temperatures in the case of molten precursor resins or any reasonable combination of these possibilities.

As liquid or viscous precursor resin may be used: a prepolymer composition containing at least one monomer or oligomer component having at least one polymerizable C=C double bond as well as at least one multifunctional monomer component, wherein the multifunctional monomer component contains at least two functional groups selected from the group consisting of (meth)acrylates, methyl (meth)acrylates, vinyl ethers, allyl ethers, propenyl ethers, alkenes, dienes, unsaturated esters, allyl triazines, allyl isocyanates, and N-vinyl amides wherein the monomer or oligomer component having at least one polymerizable double bond is selected from the group consisting of (meth)acrylates, methyl (meth)acrylates, vinyl ethers, allyl ethers, propenyl ethers, alkenes, dienes, unsaturated esters, allyl triazines, allyl isocyanates, and N-vinyl amides, and wherein at least one surface-active anti-adhesive additive selected from the group consisting of alkyl-(meth)acrylates, poly-siloxane (meth)acrylates, (per)fluoroalkyl (meth)acrylates, (per)fluoropolyether (meth)acrylates, alkyl vinyl ethers, polysiloxane vinyl ethers, (per)fluoroalkyl vinyl ethers, and (per)fluoropolyether vinyl ethers. In an embodiment, the precursor resin is free of solvents or comprises at most 1 wt.-% of solvents, at most 2 wt.-% of solvents, at most 3 wt.-% of solvents, at most 4 wt.-% of solvents or at most 5 wt.-% of solvents. Solvents according to the present application are all fluids that are able to dissolve a reasonable amount of resin and which, at the same time, have a vapor pressure of 30 hPa or more at 25°C.

Examples of typical peel forces of successful and unsuccessful peels are shown in Table 1. The peel tests were performed according to the ISO 8510-2 test standard using a 180° peel. In these tests, two types of materials were used as precursor resins for the first three-dimensional texture (article) and the coating:
- Material A: a UV-curable acrylate resin
- Material B: a UV-curable acrylate resin with a perfluorinated component
The tested first three-dimensional texture is a pyramid array with 30-µm high features with a base of 50 × 50 µm. Both the first three-dimensional texture and the coating are fabricated on 250-µm thick PET substrates. The substrate with the first three-dimensional texture was mounted on a rigid carrier in order to perform the peeling test. The coatings were applied by dispensing of the precursor resin, which is solvent-free, on the first three-dimensional texture, followed-by the lamination of the precursor resin on the first three-dimensional texture with a plastic foil, and the subsequent UV curing of the coating resin.

The results show that the removal of the coating is successful when both the textured article and the coating are made of material B (containing the perfluorinated component) or when a surface treatment is performed on material A. In this case, the peel force required to separate the coating from the first three-dimensional layer is low, i.e. below around 25 N/m. Applying the self-assembled passivation layer results in the easiest peel (i.e. the lowest peel force) since in contrast to the atmospheric plasma treatment, the passivation layer does not only neutralize active surface groups, but also reduces the surface free energy to a value lower than 40 mN/m.

When the self-assembled passivation layer is not applied onto the article, then the combination of materials A and B, for example when the textured article is made of material A and the coating is made of material B, or vice versa, results in a peel force in the medium range of about 25 - 80 N/m. In this medium range, the peel force required to separate the two layers is sufficiently high for the adhesion between one of the textured layers and its corresponding substrate material to become the weakest link. When both materials consist of material A, then the peel force required to separate the coating from the first three-dimensional layer is high, i.e. above 80 N/m, which results into failing cohesion within the layer stack.

**Table 1: Peel test results of textured articles and coatings made of two materials (A and B). In two of the tests, a surface treatment was performed on the article to enable a successful separation with the coating.**

| **Test ID** | **Article material** | **Coating material** | **Article treatment** | **Peel force (N/m)** | **Peel result** |
|---|---|---|---|---|---|
| **1** | A | A | None | High | failing cohesion of the layer stack |
| **2** | B | A | None | Medium | partly failing article/substrate adhesion |
| **3** | A | B | None | Medium | partly failing coating/substrate adhesion |
| **4** | B | B | None | Low | successful peel of the coating from the article |
| **5** | A | A | atmospheric plasma | Low | successful peel of the coating from the article |
| **6** | A | A | self-assembled passivation layer | Low | successful peel of the coating from the article |

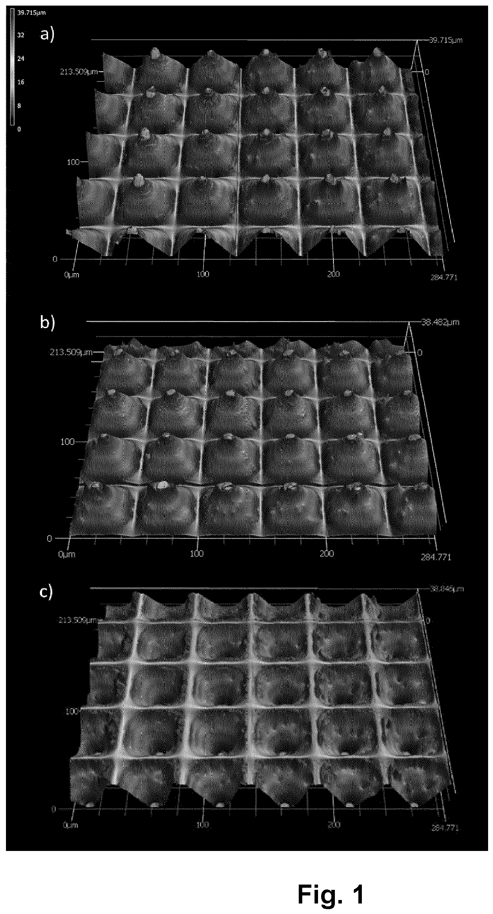

Fig. 1 shows 3D images of a first three-dimensional texture before (a) and after (b) application and removal of the coating as performed in test 5, and the corresponding 3D image of the coating after removal from the article (c). No damage or residues can be seen on the textured article after removal of the coating. Furthermore, the texture of the coating is an essentially exact negative image of the article.

## Claims

1. A substrate, the substrate comprising,
• at least one surface comprising a first three-dimensional texture and
• a removable coating
**characterized in that**
• the coating covers the first three-dimensional texture,
• the coating comprises a second three-dimensional texture,
• the second three-dimensional texture is in contact with the first three-dimensional texture,
• which second three-dimensional texture is an essentially exact negative image of the first three-dimensional texture.

2. The substrate of claim 1 where the substrate can be rectangular, square, circular or of any other planar shape.

3. The substrate of claim 1 or 2, wherein the first three-dimensional texture is comprised in a layer on the surface of the substrate.

4. The substrate of claim 3, wherein the peel strength between the substrate and the layer is larger than the peel strength between the layer and the coating as well as larger than the cohesive strength of any of the utilized materials.

5. The substrate of claim 3 or 4, wherein the layer comprises an acrylic resin, siloxane units, epoxide groups, or fluor-organic groups or any combination thereof.

6. The substrate of any one or more of the previous claims, wherein the coating comprises an acrylic resin, siloxane units, epoxide groups, or fluor-organic groups or any combination thereof.

7. The substrate of any one or more of the previous claims, wherein the coating comprises at most 5 wt.-% of solvents.

8. The substrate of any one or more of the previous claims, wherein the coating is adhered to a plastic film.

9. The substrate of any one or more of the previous claims, wherein the coating comprises more than one layer.

10. The substrate of any one or more of the previous claims, wherein the coating does not leave any residues on the surface of the first three-dimensional texture after removing it from this first three-dimensional texture.

11. Process for application of a coating onto a substrate, the substrate comprising a three-dimensional texture comprising the steps of
• Providing a substrate comprising a three-dimensional texture,
• Providing a liquid or viscous precursor resin using a coating process in such a way that the liquid precursor resin fills the three-dimensional texture,
• Solidifying the liquid precursor resin to obtain the coating.

12. Process of claims 11 wherein the precursor resin is applied in a printing process.

13. Process of claim 11 or 12 wherein the liquid or viscous precursor resin is applied using a textured or non-textured mold or stamp.
